## Europäisches Patentamt

## European Patent Office

## Office européen des brevets

(11) Veröffentlichungsnummer: **0 390 967**
**A2**

(12) **EUROPÄISCHE PATENTANMELDUNG**

(21) Anmeldenummer: **89118789.0**

(22) Anmeldetag: **10.10.89**

(51) Int. Cl.⁵: **C25D 3/38**

Ein Antrag gemäss Regel 88 EPÜ auf Berichtigung der Anmeldungsunterlagen liegt vor. Über diesen Antrag wird im Laufe des Verfahrens vor der Prüfungsabteilung eine Entscheidung getroffen werden (Richtlinien für die Prüfung im EPA, A-V, 2.2).

(30) Priorität: **24.10.88 DE 3836521**

(43) Veröffentlichungstag der Anmeldung:
**10.10.90 Patentblatt 90/41**

(84) Benannte Vertragsstaaten:
**BE CH DE ES FR GB IT LI LU NL SE**

(71) Anmelder: **SCHERING AKTIENGESELLSCHAFT Berlin und Bergkamen**
**Müllerstrasse 170/178 Postfach 65 03 11**
**D-1000 Berlin 65(DE)**

(72) Erfinder: **Dahms, Wolfgang**
**Hermsdorfer Strasse 53A**
**D-1000 Berlin 26(DE)**

(54) **Wässriges saures Bad zur galvanischen Abscheidung von glänzenden und rissfreien Kupferüberzügen und Verwendung dieses Bades.**

(57) Die Erfindung betrifft ein wässriges saures Bad zur galvanischen Abscheidung von glänzenden und rissfreien Kupferüberzügen, insbesondere zur Verstärkung der Leiterbahnen von gedruckten Schaltungen mit hervorragender Bruchelongation, das mindestens ein Kupfersalz, mindestens eine anorganische Säure und gegebenenfalls ein Chlorid sowie eine eine Amidgruppe aufweisende Verbindung, eine organische Thioverbindung mit wasserlöslich machenden Gruppen und gegebenenfalls eine sauerstoffhaltige, hochmolekulare organische Verbindung enthält, gekennzeichnet durch einen Gehalt an mindestens einem gegebenenfalls substituierten Lactamalkoxylat als Amidgruppe aufweisende Verbindung.

EP 0 390 967 A2

# Vorrichtung zum Galvanisieren oder chemischen Behandeln von metallischen Teilen

Die Erfindung betrifft eine Vorrichtung zum Galvanisieren oder chemischen Behandeln von metallischen Teilen gemäß dem Oberbegriff des Anspruches 1. Der Vollständigkeit halber sei erwähnt, daß der Ausdruck "Galvanisieren" oder "Chemisches Behandeln" jegliche Art von außenstromloser Galvanisation oder chemischer Oberflächenbehandlung bzw. -auftrag von sperrigen Teilen umfaßt, z.B. chemisches Vernickeln. Eine solche Vorrichtung ist für die Galvanisierung von Massenartikeln, wie kleinen Gegenständen (Schrauben, Bolzen, Muttern und dergleichen) aus DE-OS 31 27 390 bekannt. Die kleinen Gegenstände werden am Eingang der Vorrichtung mit Hilfe eines Trichters auf ein in einem Bad laufendes Förderband aufgegeben, von diesem aus dem Bad gehoben und mit Hilfe eines weiteren Trichters einer Trommel zugeführt, welche die kleinen Gegenstände in einem anderen Bad bewegt, wobei die Galvanisierung erfolgt. Beim Drehen der Trommel werden diese Gegenstände mittels spiralförmig in der Trommel vorgesehenen Rippen vom eingangsseitigen zum ausgangsseitigen Ende der Trommel gefördert und dort auf ein Förderband gegeben, das über den Flüssigkeitsspiegel hinausreicht und die Gegenstände in ein anderes Bad abwirft, aus dem sie mittels eines weiteren Förderbandes herausgeholt werden. Hiermit ist zwar ein fortlaufender, kontinuierlicher Transport dieser Gegenstände in Art eines Stranges von der Eingangs- zur Ausgangsseite unter gleichzeitiger Galvanisierung gegeben. Doch is die aus DE-OS 31 27 390 bekannt Anordnung nur für die Förderung und Behandlung solcher kleiner Gegenstände, wie Schrauben, Muttern, usw. geeignet. Außerdem befaßt sich diese Literaturstelle nur mit der Behandlung dieser kleinen Gegenstände in einem einzigen Galvanisierbad, nämlich dem die Behandlungstrommel aufnehmenden Bad.

Die Aufgabe der Erfindung besteht demgegenüber darin, eine Vorrichtung gemäß dem Prinzip des Oberbegriffes des Anspruches 1 dahingehend auszugestalten, daß mit ihr auch sperrige Teile erfaßt und in größeren Galvanisieranlagen mit einer größeren Anzahl hintereinander angeordneter Flüssigkeitsbecken kontinuierlich behandelt werden können und zwar ohne spürbare Verschleppung von Flüssigkeit eines Bades in die Flüssigkeit des in Förderrichtung nachfolgenden Bades. Dabei ist z.B. an aus Draht gebogene Teile gedacht, die zu vernickeln sind. Solche Drahtbügel sind relativ sperrig und können daher nicht in einer umlaufenden Trommel galvanisch behandelt werden, da sie sich hierbei miteinander zu Klumpen verhaken würden. Solche Drahtbügel und ähnliche sperrige Teile werden vielfach in der Technik benötigt. Als bevorzugtes, aber keineswegs ausschließliches Anwendungsgebiet sei an Drahtbügel gedacht, die in Briefordnern befestigt und durch die Lochungen der abzulegenden Blätter hindurchgeführt werden.

Die Lösung dieser Aufgabe wird zunächst, ausgehend vom Oberbegriff des Anspruches 1, in den Merkmalen des Kennzeichens des Anspruches 1 gesehen. Hiermit ist sowohl der Halt als auch der Transport der sperrigen Teile möglich, wobei - sofern erforderlich - auch eine Vereinzelung der sperrigen Teile erfolgen kann. Die Teile werden dabei praktisch über die gesamte Länge des jeweiligen Flüssigkeitsbehälters in dessen Bad oder Flüssigkeit geführt, d.h. entsprechend behandelt, wobei zum Begriff des Behandelns nicht nur die eigentliche Galvanisierung, sondern auch alle anderen Vorgänge gehören, wie: Heißentfetten, Standspülung, Fließ-Spülung, Beizen, Vortauchen, Nachtauchen usw. Jede Flüssigkeit ist von der anderen Flüssigkeit durch entsprechende Trennwände (die auch durch die Wände der Flüssigkeitsbecken gebildet sein können) voneinander getrennt. Da die sperrigen Teile vom jeweiligen Förderband oder -kette aus jedem Bad herausgenommen werden, tropft die an ihnen befindliche Flüssigkeit nahezu vollständig ab, bis sie oberhalb der betreffenden Trennwand an das Förderband oder -kette des nächstfolgenden Bades bzw. Flüssigkeitsbeckens abgegeben werden. Die Verunreinigung des in Förderrichtung nachfolgenden Bades durch die Flüssigkeit des vorhergehenden Bades ist somit minimal. Dabei ist es von Vorteil, daß im Gegensatz zu anderen galvanischen Anlagen hier aufwendige Durchtritte für das zu galvanisierende Gut im Höhenbereich der jeweiligen Badflüssigkeit vermieden sind. Wesentlich ist ferner, daß die sperrigen Teile vom jeweiligen Förderband oder -kette auch erfaßt und gehalten werden können. Dies ist nicht nur für den Transport selber nötig, sondern schafft auch eine zumindest gewisse Vereinzelung der Teile. Es ist ersichtlich, daß die Kombination der vorstehend erläuterten Maßnahmen bei solchen sperrigen, zu galvanisierenden Teilen die erfindungsgemäße Aufgabe löst. Wenn der Einfachheit halber von Förderband oder Förderkette gesprochen wird, so sind hierunter auch Vorrichtungen zu verstehen, die mit mehreren Förderbändern oder mehreren Förderketten innerhalb eines Bades oder Flüssigkeitsbeckens arbeiten.

Diese horizontal verlaufende Transportvorrichtung solcher sperrigen Teile erspart ganz erhebliche Arbeitskosten. So war es bisher üblich, die erläuterten Drahtbügel von Briefordnern zunächst durch Hilfskräfte von Hand an Gestellen aufhängen zu lassen. Hierauf wurden die Gestelle durch die Galvanisieranlage hindurch geführt. Anschließend mußten die fertig behandelten Drahtbügel wieder von Hand von den Gestellen abgenommen werden. Zu dieser Ersparnis an Personalkosten kommt die Ersparnis in der Herstellung einer solchen Anlage hinzu, deren Herstellungskosten relativ gering sind. In dem Zusammenhang ist auch zu beachten, daß bei einer solchen Galvanisierung eine größere Anzahl von sogenannten Modulen (d.h. Flüssigkeitsbecken mit verschiedenen Bädern, Spülflüssigkeiten usw.) durchlaufen werden mußten. Dabei ist ein kontinuierlicher Transport und eine Vereinfachung der Transportmittel, sowie Verhinderung der Verschleppung von Badflüssigkeit in das jeweils nachfolgende Modul für den technischen Erfolg bei geringen Herstellungskosten entscheidend. Abgesehen von einer etwaigen Beobachtung der Anlage (einschließlich der Einspeisung und Abführung der sperrigen Teile) ist kein Bedienungspersonal mehr erforderlich.

Die Ausführungsform gemäß Anspruch 2 beinhaltet ein in der jeweiligen Flüssigkeit umlaufendes Förderband oder -kette, auf dem die sperrigen Teile liegen. Damit sind gesonderte Führungen oder dergleichen im jeweiligen Flüssigkeitsbecken nicht erforderlich.

In der Ausführung gemäß Anspruch 5 sind entsprechende Förderketten vorgesehen) welche mit Mitnehmern oder Haken die sperrigen Teile erfassen. Hiermit wird verstärkt eine Vereinzelung der sperrigen Teile erreicht, da jeder sperrige Teil an einem der Mitnehmer oder Haken der Kette aufgehängt wird.

Anspruch 9 beinhaltet eine Ausführungsform der Erfindung, bei welcher das Förderband oder die Förderkette nicht im jeweiligen Bad umläuft. Damit wird ein etwaiges chemisches Angreifen des Materials des Förderbandes oder der Förderkette durch das Bad vermieden. Außerdem wird hiermit die Menge an eventuell in das nächste Bad noch zu verschleppender Badflüssigkeit reduziert, da hierfür nur noch die Flüssigkeitsreste (Tropfen) infrage kommen, die sich an den sperrigen Teilen selber befinden.

Weitere Vorteile und Merkmale der Erfindung sind den weiteren Unteransprüchen, sowie der nachfolgenden Beschreibung und der zugehörigen Zeichnung von erfindungsgemäßen Ausführungsbeispielen zu entnehmen. In der Zeichnung zeigt:

Fig. 1: eine Anlage nach der Erfindung in der Draufsicht,

Fig. 2: schematisch die dazugehörige Seitenansicht,

Fig. 3: im vergrößerten Maßstab das Beispiel eines mit der Erfindung in einer solchen Galvanisieranlage zu transportierenden sperrigen Drahtbügels,

Fig. 4: im gegenüber Fig. 1, 2 vergrößerten Maßstab einen Ausschnitt aus einer solchen Anlage in der Seitenansicht und zum Teil im Schnitt,

Fig. 5: einen Schnitt gemäß der Linie V-V in Fig. 4,

Fig. 6: ein weiteres Ausführungsbeispiel der Erfindung in Form eines Ausschnittes aus einer Anlage gemäß Fig. 2 und zwar in einem Längsschnitt, im vergrößerten Maßstab,

Fig. 7: einen Schnitt gemäß der Linie VII-VII in Fig. 6,

Fig. 8: eine dritte Ausführungsform der Erfindung ebenfalls im Ausschnitt aus einer Anlage gem. Fig. 2 und im demgegenüber vergrößerten Maßstab, sowie in der Seitenansicht, zum Teil geschnitten,

Fig. 9: einen Schnitt gemäß der Linie IX-IX in Fig. 8,

Fig. 10: die Einzelheit X aus Fig. 8 im demgegenüber vergrößerten Maßstab,

Fig. 11: eine Draufsicht auf Fig. 10.

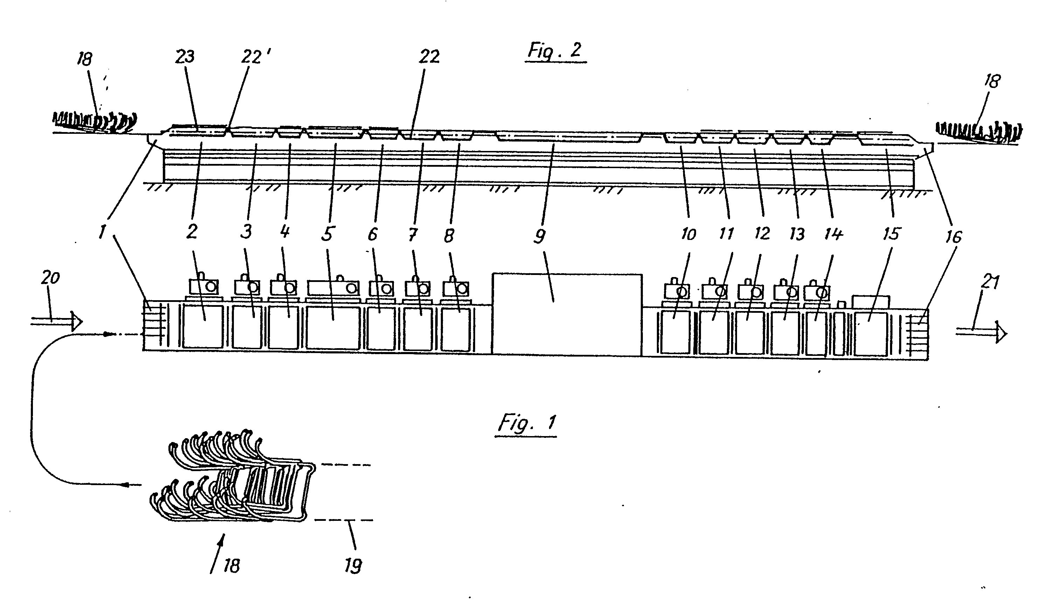

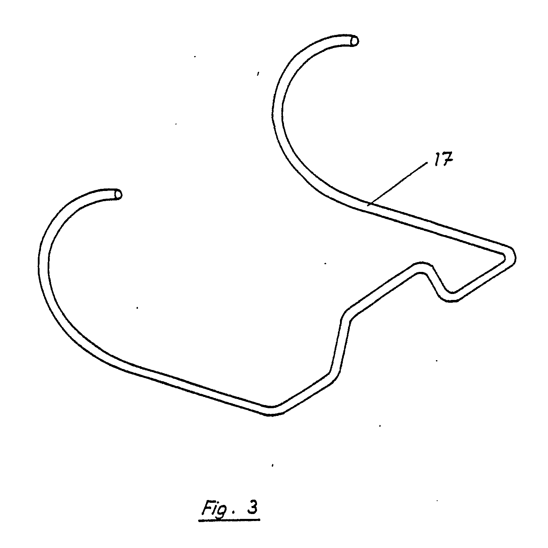

Fig. 1 zeigt die Draufsicht auf eine horizontal verlaufende Anlage für das chemische Vernickeln. Dabei bedeuten in dieser schematischen Darstellung die Ziffern 1 bis 16 die Stationen bzw. Module: 1 Beladen, 2 Heißentfetten, 3 Standspülen, 4 Fließ-Spülen, 5 Beizen, 6 Standspülen, 7 Fließ-Spülen, 8 Vortauchen, 9 Chem. Nickel, 10 Standspülen, 11 Standspülen, 12 Fließ-Spülen, 13 Nachtauchen, 14 Warmspülen, 15 Trocknen und 16 Entladen. Im vorliegenden Ausführungsbeispiel sollen Drahtbügel 17 zur Herstellung der Schließ- und Haltevorrichtung von Briefordnern chemisch vernickelt werden. Ein solcher Bügel ist im vergrößerten Maßstab der Fig. 3 zu entnehmen. Eine Reihe 18 von hintereinander angeordneten Bügeln 17 kommt z.B. in einer Förderrinne 19 von einer in der Zeichnung nicht dargestellten Drahtbiegemaschine und wird gemäß Pfeil 20 der Beladestation 1 der Anlage zugeführt. In diesem Beispiel sind fünf Spuren mit einer entsprechenden Anzahl von Förderbändern oder -ketten, denen jeweils die Bügel 17 zugeführt werden, so daß also fünf solche Spuren durch die Anlage hindurch laufen. Die Abfuhr erfolgt nach erfolgter Behandlung gemäß Pfeil 21. In Fig. 2 zeigt die durchgezogene Linie 22 schematisch den Verlauf der sperrigen Teile, während die strichpunktierte Linie 23 den Flüssigkeitsspiegel der Bäder oder Flüssigkeiten in den einzelnen Modulen 2 bis 15 angibt. Hieraus ergibt sich, daß der Warenverlauf 23 innerhalb der Module unterhalb des Flüssigkeitsspiegels 23 stattfindet. Dagegen verläuft die Ware beim Übergang von einem Modul oder Flüssigkeitsbekken zum nächsten gemäß Ziff. 22' über den Flüssigkeitsspiegel nach oben über die dort vorgesehene Trennwand und in das nächste Modul bzw. Flüssigkeitsbecken hinein, um dort wieder unterhalb des Flüssigkeitsspiegels 23 transportiert und behandelt zu werden.

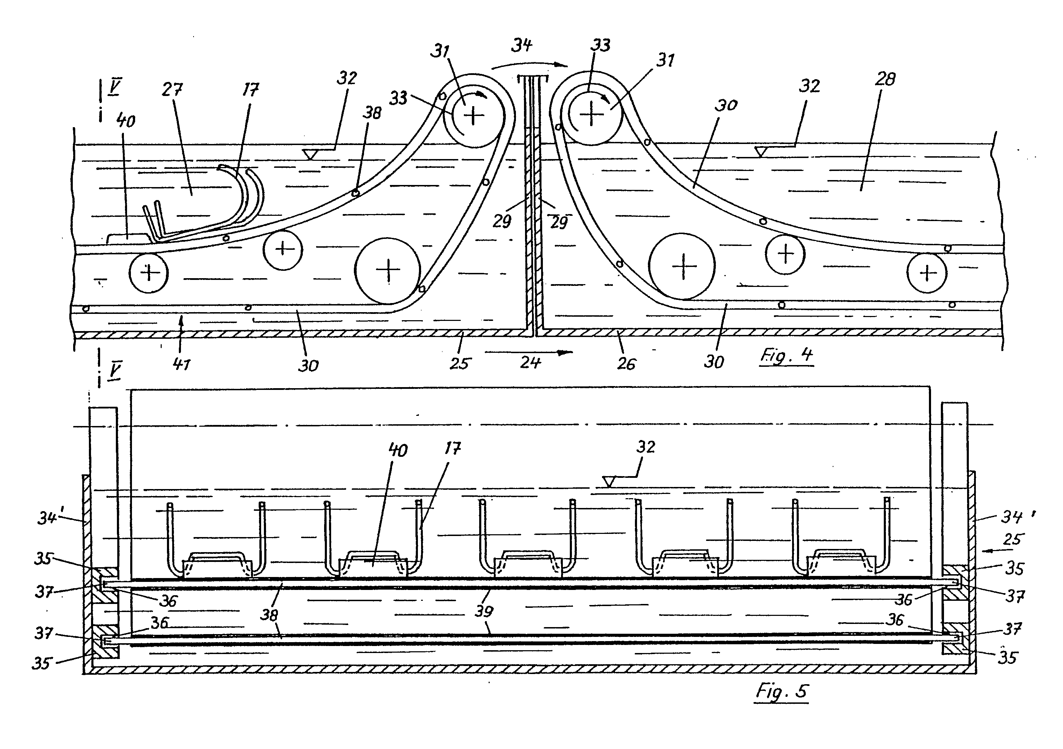

Das Ausführungsbeispiel der Fig. 4 und 5 zeigt zwei aneinander in Förderrichtung 24 angrenzende Module bzw. Flüssigkeitsbecken 25, 26 mit Flüssigkeitsbädern 27, 28, wobei die Bäder in der Regel voneinander verschieden sind. Die aneinander grenzenden Wände 29 dieser beiden Flüssigkeitsbecken bilden die bereits erwähnte Trennwand. In jedem Becken läuft endlos ein Förderband oder auch eine Förderkette 30 um Rollen 31 um, wobei pro Bad zumindest eine Rolle im eingezeichneten Drehsinn 33 angetrieben wird. Die Anordnung ist so getroffen, daß das Förderband oder -kette 30 nur am jeweiligen Anfang und Ende des Flüssigkeitsbeckens über den Flüssigkeitsspiegel 32 hinaus nach oben vorragt, um im Bereich 34 oberhalb der Trennwand 29 die sperrigen Teile an das nächstfolgende Förderband oder Förderkette 30 (hier die des Flüssigkeitsbeckens 26) übergeben zu können. An den sperrigen Teilen 17 noch etwa anhängende Reste des Bades 27 tropfen nach Verlassen dieses Bades weitgehend von den sperrigen Teilen ab, so daß praktisch keine Badflüssigkeit 27 in die Badflüssigkeit 28 verschleppt wird.

Der Schnitt gemäß Fig. 5 zeigt an den Längsseitenwänden 34' des Flüssigkeitsbeckens 25 bevorzugt aus gleitfähigem Kunststoff bestehende Führungen 35. Diese Führungen besitzen badseitig Führungsrinnen 36, in welche gleitend die vom Förderband oder -kette nach außen vorstehenden Enden 37 von Querstäben 38 eingreifen. Hierdurch wird von den Stoßstellen (Trennwände) der beiden Module bzw. Flüssigkeitsbecken her das jeweilige Förderband oder -kette 30 nach unten in das Bad hineingeführt. Die Teile 17 liegen auf dem Förderband lose auf oder werden von diesem mitgenommen. Die Stäbe 38 sind an einem Band 39 befestigt, bzw. durchsetzen dieses. Oberseitig sind am Band 39 Vorsprünge 40 vorgesehen, über welche die Teile 17 zu liegen kommen. Die Vorsprünge 40 sind hier der Form der zu galvanisierenden Teile angepaßt. Dieser Querschnitt zeigt auch die fünf Spuren, die im Zusammenhang mit Fig. 1 erwähnt wurden.

Jedes der Module hat ein solches Förderband oder -kette (dies gilt auch für die weiteren Ausführungsbeispiele). Die Förderbänder können aus einzelnen Abschnitten bestehen, die miteinander verbunden sind.

Im Beispiel der Fig. 4, 5 sind sowohl das obere Trum 40 als auch das untere Trum 41 des Förderbandes oder -kette 30 im jeweiligen Bad gelegen; mit Ausnahme derjenigen Teile, die nahe der jeweiligen Trennwand liegen. Gegebenenfalls könnten die Stäbe 38 auch auf der Oberseite des Bandes 39 angebracht sein, so daß sie anstelle der Vorsprünge 40 Mitnehmer für den Transport der sperrigen Teile 17 sind.

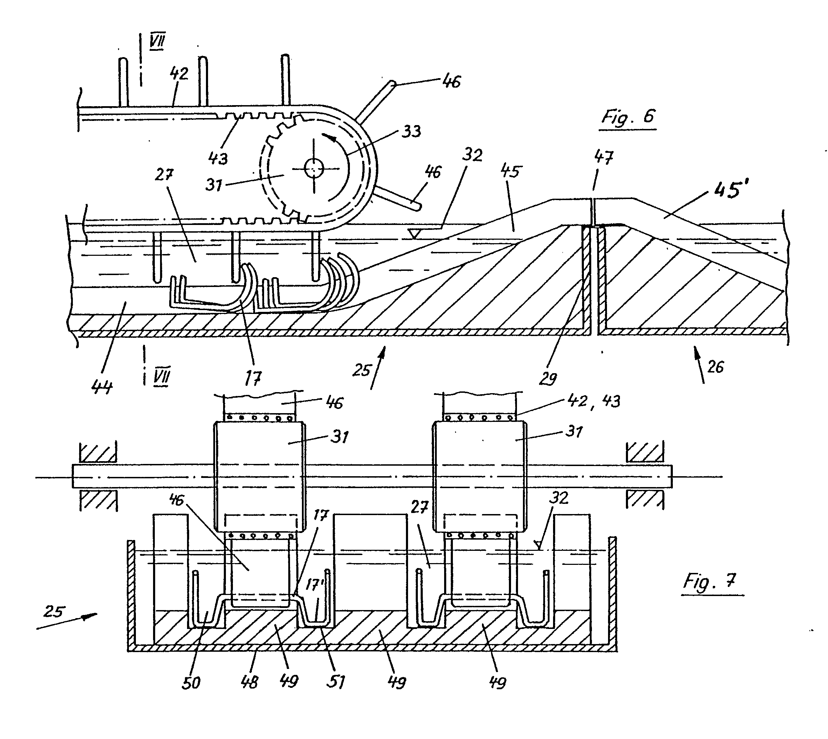

Im Beispiel der Fig. 6 und 7 ist das Förderband oder -kette, hier ein Zahnriemen 42 mit Zahnung 43, oberhalb des Flüssigkeitsspiegels 32 vorgesehen und wird von der Antriebsrolle 31 in Pfeilrichtung 33 gedreht. Fig. 6 zeigt das ausgangsseitige Ende des zugehörigen Flüssigkeitsbeckens 25. Es versteht sich, daß das hier nicht gezeigte eingangsseitige Ende des Beckens 25 sinngemäß gestaltet ist. Für den Transport der Teile 17 von der Eingangs- zur Ausgangsseite des Beckens 25 sind Auflageflächen, hier in Form von Führungen 44, 45 vorgesehen. Die horizontal verlaufende Führung 44 geht ausgangsseitig in eine ansteigende Führung 45 über, welche über den Flüssigkeitsspiegel 32 hinaus bis in den Übergabebereich 47 an das nächstfolgende Becken verläuft. Eine analoge, schräg verlaufende Rinne, befindet sich eingangsseitig dieses Beckens. Sie führt von dem entsprechenden Übergabebereich der Trennwand 29 schräg nach unten bis zur Führung 44. Die Führung 44 und die unteren Bereiche der ansteigenden Führungen befinden sich unterhalb des Flüssigkeitsspiegels 32. Am Zahnriemen 42 sind außenseitig Mitnehmer 46 angebracht, die so lang sind, daß sie an den in den Führungen 44 befindlichen Teilen 17 angreifen und sie in der Förderrichtung 24 bis zu der oberhalb der Trennwand 29 sich befindenden Übergabestelle 47 verschieben. Sie gelangen in die Führung 45', die schräg nach unten in das nächstfolgende Becken 26 hineinführt. Es kommen also nur die Mitnehmer 46 des Förderbandes mit der Flüssigkeit in Berührung, wodurch die Menge an etwa aus dem Becken 25 in das Becken 26 zu verschleppender Flüssigkeit weiter reduziert wird. Die Bänder können mit Mitnehmernoppen versehen sein.

Fig. 7 zeigt eine Ausführungsmöglichkeit in der Ausgestaltung der Führungen 44 bzw. entsprechender Auflageflächen oder Querschnittsausbildungen am Boden 48 dieses Beckens 25. Diese Ausführung ist dem Querschnitt der Teile 17 angepaßt, wobei diese Teile wie dargestellt nach außen gerichtete Abwinkelungen 17' aufweisen können. Die Führungen bestehen hier aus einem im Schnitt rechteckigen oder quadratischen Vorsprung 49, der sich vom Boden 48 her nach oben erstreckt und über den Teil 17 paßt. Zwischen diesen Vorsprüngen 49 ist Raum 50 für die Unterbringung der Abwinkelungen 17' vorgesehen. Es empfiehlt sich, die Vorsprünge 49 und auch die Auflageflächen 51 unterhalb der Räume 50 aus einem Kunststoff mit guten Gleiteigenschaften herzustellen, um den Transport der Teile 17 zu erleichtern. Für diesen Fall sind zwei Spuren dargestellt. Es könnte aber auch hier die Spurzahl anders, z.B. fünf, sein. Die Führungen könnten aber auch anders ausgebildet sein, z.B. rinnen- oder trogförmig. Auch in diesem Ausführungsbeispiel kann anstelle eines Förderbandes eine entsprechende Anzahl von Förderketten vorgesehen sein, die miteinander die Spuren bilden.

Die Übergabestationen können mit einer Vereinzelungsvorrichtung versehen sein.

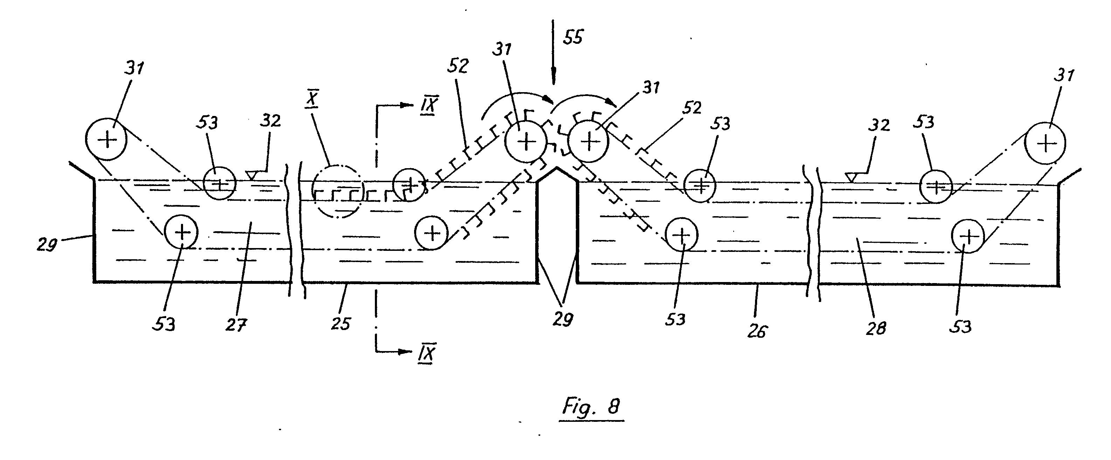

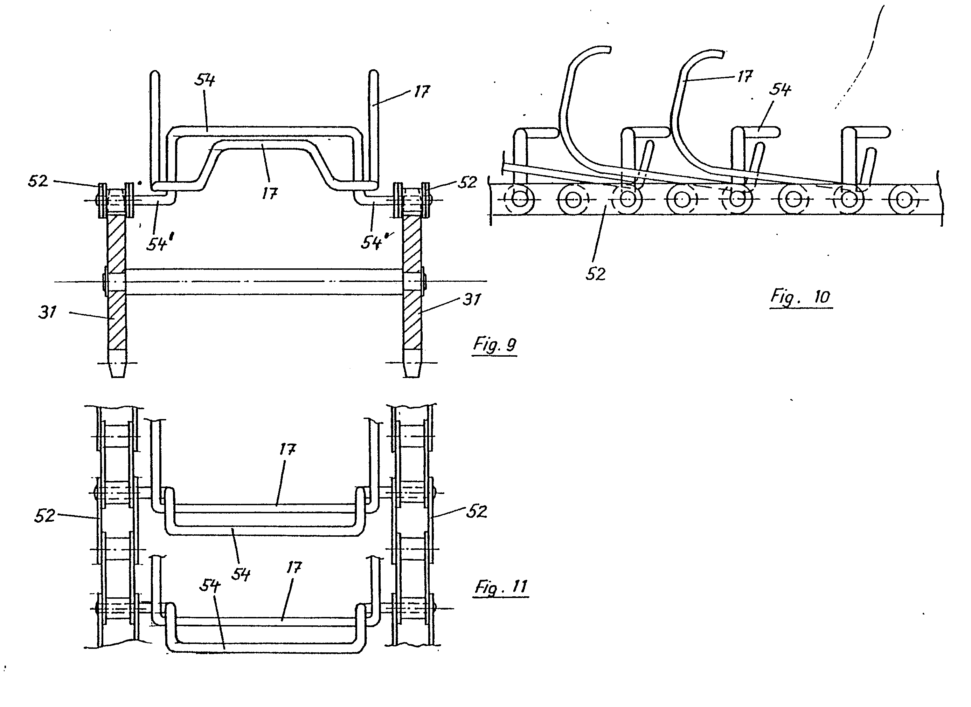

Schließlich zeigt das Ausführungsbeispiel der Fig. 8 bis 11 als Transport- oder Fördermittel Ketten 52, die jeweils endlos in einem Flüssigkeitsbecken 25 bzw. 26 umlaufen, wobei der Verlauf etwa dem der Förderbänder 30 im Beispiel der Fig. 4, 5 entspricht. Entweder durch Führungen 35 bis 37 gemäß Fig. 5 oder durch in diesem Ausführungsbeispiel gezeigte Rollen 53 ist dafür gesorgt, daß von den jeweils oberen Rollen 31 her die Ketten vom übergabebereich 55 oberhalb der Trennwände 29 unter den Flüssigkeitsspiegel 32 in das Bad 27 eingeführt werden, so daß die von ihnen mit bewegten Teile 17 über den größeren Transportbereich sich in der Flüssigkeit des zugehörigen Beckens befinden. Auch hier können mehr als zwei Ketten und entsprechende Anzahl von Spuren nebeneinander vorgesehen sein. Die prinzipielle Wirkungsweise, insbesondere die der Übergabe, sind analog denen der zuvor erläuterten Ausführungsbeispiele . Zwischen zwei zusammengehörenden Ketten 52 erstrecken sich Mitnehmer 54, welche die Teile 17 ergreifen und transportieren können (siehe Fig. 9 bis 11). Die Mitnehmer 54 sind in Anpassung an die Form der Teile 17 U-förmig mit zur Seite gerichteten Abwinkelungen 54', die an den Ketten 52 angebracht sind. Statt der Mitnehmer 54 könnten sich an den Ketten Haken (nicht dargestellt) befinden, welche die zu galvanisierenden Teile erfassen. Die sperrigen Teile 17 in Form dieser Bügel können auch stehend antransportiert werden und werden dann von den Haken erfaßt. Die Mitnehmer 54 haben ferner die Funktion, die beiden Ketten 52 auf Distanz voneinander zu halten und damit eine umlaufende Fördereinheit zu bilden. Fig. 8 zeigt, daß die Ketten beider Flüssigkeitsbecken an der Übergabestelle 55 sich soweit nahekommen, daß auch hier die Teile 17 von einer Kette auf die nächste Kette übergeworfen und dort weiter transportiert werden.

## Ansprüche

1. Vorrichtung zum Galvanisieren von metallischen Teilen, die von einer Eingabestation über eine der Galvanisierung dienenden Badanordnung bis zu einer Ausgabestation geführt werden, wobei der Durchlauf der Teile im wesentlichen in der Horizontalen verläuft und dabei die Teile über eine Trennwand zwischen zwei mit Flüssigkeit gefüllten Becken hinüber bewegt werden), dadurch gekennzeichnet, daß zur Galvanisierung von sperrigen Teilen, insbesondere Drahtteilen (17), mit Hilfe einer größeren Anzahl von Flüssigkeitsbecken (2 bis 14, 25, 26) in jedem Flüssigkeitsbecken ein Förderband bzw. -kette (30, 42, 52) umläuft, das mit Mitteln zum Erfassen oder Halten und zum Fördern der einzelnen sperrigen Teile (17) unterhalb des Flüssigkeitsspiegels (32), sowie gegebenenfalls auch zum Vereinzeln der Teile, versehen ist, daß am Anfang und am Ende des jeweiligen Flüssigkeitsbeckens das Förderband bzw. -kette bis zu einem Übergabebereich (34, 47, 55) oberhalb der Trennwände (29) zwischen zwei in Förderrichtung (24) aufeinander folgenden Flüssigkeitsbecken geführt ist, so daß für eine, gegebenenfalls vereinzelte, Übergabe der sperrigen Teile von dem einen Flüssigkeitsbecken (27) zu dem in Förderrichtung (24) nachfolgenden Flüssigkeitsbecken und zwar auf dessen Förderband oder -kette gesorgt ist.

2. Vorrichtung nach Anspruch 1, dadurch gekennzeichnet, daß das Förderband oder -kette (30) mit Ausnahme des Eingangsbereiches und des Ausgangsbereiches des jeweiligen Flüssigkeitsbeckens (25, 26) unterhalb des Flüssigkeitsspiegels (32) verläuft und daß das Förderband bzw. -kette entweder mittels Rollen oder durch seitlich von ihm vorstehende Führungsmittel mit seinem oberen und unteren Trum unterhalb des Flüssigkeitsspiegels (32) geführt ist.

3. Vorrichtung nach Anspruch 2, dadurch gekennzeichnet, daß das Förderband oder -kette (30) in seiner Umlaufrichtung verlaufende Riemen, Bänder, Ketten oder dergleichen, sowie quer dazu verlaufende Stäbe (38) aufweist, wobei die Enden dieser Stäbe nach außen vorstehen und Führungsstifte bilden, und daß die Innenwand des Flüssigkeitsbeckens (34) Führungsteile (35) mit Rinnen (36) aufweist, die entsprechend der gewünschten Längsrichtung des Förderbandes oder -kette verlaufen und als Gleitführungen für die in sie eingreifenden Enden der Stäbe (38) dienen.

4. Vorrichtung nach Anspruch 3, dadurch gekennzeichnet, daß sich die Stäbe (38) auf der Oberseite des Förderbandes oder -kette befinden und somit zugleich als Mitnehmer für die sperrigen Teile (17) dienen.

5. Vorrichtung nach Anspruch 1 oder 2, gekennzeichnet durch zumindest zwei in Umlaufrichtung verlaufende Ketten (52), die in Umlaufrichtung im Abstand angeordnete Mitnehmer (54) oder Haken für das Erfassen der sperrigen Teile (17) aufweist.

6. Vorrichtung nach Anspruch 5, dadurch gekennzeichnet, daß die Ketten (52) durch die Mitnehmer (54) auf Distanz gehalten sind.

7. Vorrichtung nach Anspruch 5 oder 6, dadurch gekennzeichnet, daß die Mitnehmer etwa U-Form haben und gegebenenfalls an den freien Enden ihrer Schenkel nach außen ragende Abwinkelungen (54') tragen.

8. Vorrichtung nach einem der Ansprüche 5 bis 7, gekennzeichnet durch eine Form und Größe der Mitnehmer (54), welche der Form und Größe der zu erfassenden und zu fördernden sperrigen Teile (17) angepaßt ist.

9. Vorrichtung nach Anspruch 1, dadurch gekennzeichnet, daß im Flüssigkeitsbecken Auflageflächen (44, 45) für die sperrigen Teile (17) vorgesehen sind, wobei diese Auflageflächen am Anfang des Flüssigkeitsbeckens von der Oberkante der betreffenden Trennwand (29) zum Boden des Flüssigkeitsbeckens hin abfallen, am Boden waagerecht verlaufen und am Ende des Flüssigkeitsbeckens zur betreffenden Trennwandoberkante hin ansteigen, wobei die Förderrichtung (24) der Teile vom Anfang zum Ende des jeweiligen Beckens hin gerichtet ist.

10. Vorrichtung nach Anspruch 9, dadurch gekennzeichnet, daß die Auflageflächen als rinnen- oder trogförmige Führungen (44, 45) ausgebildet sind.

11. Vorrichtung nach Anspruch 9, dadurch gekennzeichnet, daß die Auflageflächen in ihrem Querschnitt der Form der zu galvanisierenden Teile (17) angepaßt sind.

12. Vorrichtung nach Anspruch 11, dadurch gekennzeichnet, daß die Führungen rechteckige oder quadratische Vorsprünge aufweisen, die sich vom Boden (48) des Flüssigkeitsbeckens her nach oben erstrecken und daß beiderseits dieser Vorsprünge (49) jeweils Raum (50) für seitlich vorragende Abschnitte (17′) der zu galvanisierenden Teile (17) vorgesehen ist.

13. Vorrichtung nach einem der Ansprüche 1 bis 12, dadurch gekennzeichnet, daß die Förderbänder oder -ketten (30, 42, 52) oberhalb (34, 47, 51) der Trennwände so aneinander genähert sind, daß die sperrigen Teile (17) von einem Förderband oder -kette auf das Förderband oder -kette des nachfolgenden Flüssigkeitsbeckens übergelegt oder -geworfen werden.

14. Vorrichtung nach einem der Ansprüche 1 bis 13, dadurch gekennzeichnet, daß mehrere, z.B. fünf, Spuren von Förderbändern oder -ketten nebeneinander vorgesehen und zum gemeinsamen Antrieb und Umlauf miteinander verbunden sind.

Fig. 2

Fig. 1

*Fig . 3*

Fig. 4

Fig. 5

*Fig. 6*

*Fig. 7*

Fig. 8

_Fig. 9_

_Fig. 10_

_Fig. 11_

EP 0 390 967 A2